# EUROPÄISCHE PATENTSCHRIFT

(11) **EP 3 244 714 B1**
(45) Veröffentlichungstag und Bekanntmachung des Hinweises auf die Patenterteilung: **25.11.2020**
(21) Anmeldenummer: 17170094.1
(22) Anmeldetag: 09.05.2017
(51) Int. Cl.: H05K 5/02

(54) **GEHÄUSE UND STELLEINRICHTUNG MIT GEHÄUSE**
HOUSING AND REGULATING UNIT WITH HOUSING
BOÎTIER ET DISPOSITIF DE RÉGLAGE COMPRENANT UN BOÎTIER

(30) Priorität: 13.05.2016 DE 102016208276
(43) Veröffentlichungstag der Anmeldung: 15.11.2017
(73) Patentinhaber: Mahle International GmbH, 70376 Stuttgart (DE)
(72) Erfinder: CICCIARELLA, Maximiliano, 71254 Ditzingen (DE); NIEKAMP, Peer, 71397 Leutenbach (DE)
(74) Vertreter: BRP Renaud & Partner mbB Rechtsanwälte Patentanwälte Steuerberater

(56) Entgegenhaltungen:
- EP-A1- 1 215 950
- EP-A2- 1 603 378
- DE-A1-102011 119 875
- JP-A- 2002 058 128
- US-B1- 6 273 426

## Beschreibung

Die vorliegende Erfindung betrifft ein Gehäuse einer elektrischen und/oder elektronischen Komponente, insbesondere einer Steuereinrichtung und/oder einer Stelleinrichtung zum mechanischen Betätigen einer Komponente einer Maschine, vorzugsweise einer Brennkraftmaschine, gemäß dem Oberbegriff des Anspruchs 1. Ferner betrifft die Erfindung eine mit einem solchen Gehäuse ausgestattete Steuereinrichtung bzw. Stelleinrichtung. Die Erfindung betrifft außerdem eine mit einer solchen Stelleinrichtung ausgestattete Maschine.

Bei einer Vielzahl von Maschinen gibt es Komponenten, die mechanisch betätigt werden müssen, damit die jeweilige Komponente die ihr zugeordnete Funktion innerhalb der jeweiligen Maschine erfüllen kann. Von bevorzugtem Interesse ist als Maschine hierbei ein Abgasturbolader, der als betätigbare Komponente beispielsweise eine variable Turbinengeometrie oder ein Wastegateventil aufweisen kann. Dementsprechend kann ein derartiger Abgasturbolader mit einer Stelleinrichtung ausgestattet sein, um die variable Turbinengeometrie bzw. das Wastegateventil bedarfsabhängig zu betätigen. Selbstverständlich lassen sich auch andere Maschinen mit derartigen Stelleinrichtungen ausstatten. Beispielsweise kann eine Pumpe eine solche Maschine repräsentieren, die als betätigbare Komponente ein Ventil zum Einstellen eines Volumenstroms aufweist. Mit Hilfe der Stelleinrichtung lässt sich dann das Ventil betätigen. Ebenso ist denkbar, eine Abgasrückführung als Maschine aufzufassen, die als betätigbare Komponente ein Abgasrückführventil zum Einstellen einer Abgasrückführrate aufweist. Auch diese Maschine kann mit einer Stelleinrichtung zum Betätigen des Abgasrückführventils ausgestattet sein.

Stelleinrichtungen, die sich zum mechanischen Betätigen einer Komponente einer Maschine eignen, umfassen grundsätzlich ein Gehäuse, das mehrteilig, zumindest jedoch zweiteilig, aufgebaut sein kann und dementsprechend ein erstes Gehäuseteil und ein zweites Gehäuseteil aufweist. Das Gehäuse enthält zumindest einen Innenraum, in dem ein Elektromotor angeordnet ist. Dieser Elektromotor ist mit einem Stellglied der Stelleinrichtung antriebsmäßig gekoppelt, das außen am Gehäuse angeordnet ist. Das Stellglied seinerseits ist dazu vorgesehen und adaptiert, mit der jeweiligen Komponente gekoppelt zu werden, die mit Hilfe der Stelleinrichtung betätigt werden soll. Im zusammengebauten Zustand der Stelleinrichtung sind die beiden Gehäuseteile, die separate Bauteile repräsentieren, aneinander befestigt und liegen dabei in einem Kontaktbereich aneinander an. Dieser Kontaktbereich läuft in einer Umfangsrichtung des Gehäuses entlang des Innenraums geschlossen um.

Auch andere elektrische und/oder elektronische Komponenten besitzen ein Gehäuse, in dem elektrische und/oder elektronische Bauteile und/oder Baugruppen zum Schutz vor Umwelteinflüssen untergebracht sind. Von besonderem Interesse sind dabei Steuereinrichtungen mit elektrischen und/oder elektronischen Elementen. Beispielsweise kann es sich um eine Steuereinrichtung zum Ansteuern einer Stelleinrichtung der vorstehend beschriebenen Art handeln. Das Gehäuse der Steuereinrichtung kann dabei zumindest teilweise in das Gehäuse der Stelleinrichtung integriert sein.

Je nach Einsatzort der Stelleinrichtung bzw. der Steuereirichtung kann diese bzw. das Gehäuse Temperaturen ausgesetzt sein, die in einem relativ großen Temperaturbereich variieren. Dies gilt insbesondere für Anwendungen im Bereich einer Brennkraftmaschine. Im Innenraum des Gehäuses befindet sich herstellungsbedingt ein gewisses Luftvolumen, das sich abhängig von der Temperatur zusammenziehen oder ausdehnen möchte. Bei einem hermetisch verschlossenen Gehäuse würde dies zu entsprechenden Druckänderungen im Innenraum führen. Variierende Drücke im Innenraum belasten jedoch die Struktur des Gehäuses. Es ist daher ein Druckausgleich zwischen dem Innenraum des Gehäuses und einer Umgebung des Gehäuses erwünscht. Für einen derartigen Druckausgleich ist es grundsätzlich möglich, am Gehäuse eine Druckausgleichsöffnung vorzusehen, beispielsweise am ersten Gehäuseteil oder am zweiten Gehäuseteil. Eine derartige Druckausgleichsöffnung hat jedoch den Nachteil, dass durch die Druckausgleichsöffnung die Gefahr besteht, dass Verunreinigungen, wie zum Beispiel Schmutzpartikel und Feuchtigkeit, in den Innenraum gelangen, was zu einer Beschädigung des Elektromotors und/oder weiterer im Innenraum angeordneter Bauteile der Stelleinrichtung führen kann. Um dies zu verhindern, ist es grundsätzlich möglich, eine derartige Druckausgleichsöffnung mittels einer für Gas bzw. Luft permeablen und für flüssige und feste Stoffe impermeablen Membran zu verschließen. Derartige Membranen sind jedoch vergleichsweise teuer, und zwar sowohl in der Herstellung als auch in der Applikation.

Aus der DE 10 2011 119 875 A1 ist eine Stelleirichtung bekannt, in deren Gehäuse ein Elektromotor, eine Steuereinrichtung und ein Getriebe untergebracht sind. Ein Getrieberad des Getriebes ist mit einer Hohlwelle ausgestattet, die aus dem Gehäuse herausgeführt ist und als Druckausgleichsöffnung dient und mit einer luftdurchlässigen Membran verschlossen ist.

Aus der EP 2 273 860 B1 und der DE 20 2006 020 493 U1 sind Druckausgleichselemente bekannt, die als separate Einheiten an ein Gehäuse angebaut werden können, um den Druckausgleich zu ermöglichen.

Ein gattungsgemäßes Gehäuse ist aus der JP 2002-058128 A bekannt. Das Gehäuse weist zwei Gehäuseteile auf, die über einen Kontaktbereich aneinander befestigt sind. In diesem Kontaktbereich ist ein Druckausgleichslabyrinth ausgebildet, das den Gehäuseinnenraum mit der Umgebung zum Druckausgleich verbindet. Das Druckausgleichslabyrinth besitzt einen Labyrinthkanal, der beim bekannten Gehäuse in der Umfangsrichtung geschlossen umläuft.

Aus der EP 1 215 950 A1 ist ein weiteres Gehäuse bekannt, das im Kontaktbereich der Gehäuseteile ein Labyrinth enthält, das dazu dient, Wasser, das in den Kontaktbereich eindringt, im Kontaktbereich zu halten und daran zu hindern, in den Gehäuseinnenraum zu fließen. Erreicht wird dies durch einen vollständig umlaufenden Kanal im Kontaktbereich, der zur Umgebung geschlossen ist und über einen engen Spalt zum Gehäuseinneren offen ist, so dass Kapillarkräfte das Wasser im Kanal halten.

Die vorliegende Erfindung beschäftigt sich mit dem Problem, für eine Stelleinrichtung der vorstehend beschriebenen Art bzw. für eine damit ausgestattete Maschine eine verbesserte Ausführungsform anzugeben, die sich durch eine preiswerte Realisierung des Druckausgleichs zwischen dem Innenraum und der Umgebung auszeichnet.

Dieses Problem wird erfindungsgemäß durch den Gegenstand des unabhängigen Anspruchs gelöst. Vorteilhafte Ausführungsformen sind Gegenstand der abhängigen Ansprüche.

Die Erfindung beruht auf dem allgemeinen Gedanken, im Kontaktbereich ein Druckausgleichslabyrinth auszubilden, das den Druckausgleich zwischen Innenraum und Umgebung ermöglicht. Hierzu ist das Druckausgleichslabyrinth einerseits an den Innenraum und andererseits an die Umgebung fluidisch angeschlossen, so dass das Druckausgleichslabyrinth den Innenraum fluidisch mit der Umgebung verbindet. Ein derartiges Druckausgleichslabyrinth ist für Gase vergleichsweise leicht durchgängig, während es für feste oder flüssige Verunreinigungen vergleichsweise undurchlässig ist. Somit lässt sich einerseits ein Druckausgleich für den Innenraum relativ einfach realisieren, während andererseits die Gefahr einer Verunreinigung des Innenraums reduziert ist. Besonders vorteilhaft an der Verwendung eines Druckausgleichslabyrinths ist, dass es sich besonders einfach bei der Herstellung der Gehäuseteile berücksichtigen lässt, so dass insbesondere zusätzliche Montagekosten entfallen. Eine preiswerte Herstellbarkeit wird dabei insbesondere dadurch realisiert, dass das Druckausgleichslabyrinth im Kontaktbereich ausgebildet wird, in dem die beiden Gehäuseteile aneinander anliegen. Hierdurch ist es insbesondere möglich, das Druckausgleichslabyrinth teilweise in dem einen Gehäuseteil und teilweise in dem anderen Gehäuseteil auszuformen bzw. so auszugestalten, dass es erst beim Zusammenbauen der beiden Gehäuseteile komplettiert wird. Mit anderen Worten, das Druckausgleichslabyrinth wird wie das Gehäuse im Kontaktbereich getrennt bzw. geteilt. Insbesondere lässt sich durch die Trennung bzw. Teilung des Druckausgleichslabyrinths im Kontaktbereich somit ein Spritzformen der Gehäuseteile realisieren, derart, dass die jeweiligen Bestandteile des Druckausgleichslabyrinths im jeweiligen Gehäuseteil integral ausgeformt sind. Hierdurch entstehen bei der Herstellung der Gehäuseteile durch die Integration des Druckausgleichslabyrinths keine wesentlichen Zusatzkosten.

Erfindungsgemäß erstreckt sich das Druckausgleichslabyrinth in der Umfangsrichtung nur entlang eines Teils des Kontaktbereichs, beispielsweise über weniger als 180°, vorzugsweise über weniger als 90°.

Erfindungsgemäß weist das Druckausgleichslabyrinth einen Labyrinthkanal auf, der sich in der Umfangsrichtung des Gehäuses nur entlang eines Teils des Kontaktbereichs von einem ersten Umfangsende bis zu einem zweiten Umfangsende erstreckt, wobei der Labyrinthkanal über eine Innenraumöffnung am ersten Umfangsende mit dem Innenraum fluidisch verbunden ist, während er über eine Umgebungsöffnung am zweiten Umfangsende mit der Umgebung fluidisch verbunden ist. Somit sind die Innenraumöffnung und die Umgebungsöffnung in der Umfangsrichtung zueinander versetzt angeordnet. Diese Bauweise hat zur Folge, dass Luft, die bei einem Überdruck im Innenraum durch das Druckausgleichslabyrinth zur Umgebung strömt oder die bei einem Unterdruck im Innenraum aus der Umgebung durch das Druckausgleichslabyrinth zum Innenraum strömt, am Übergang zwischen Innenraumöffnung und Labyrinthkanal sowie am Übergang zwischen Umgebungsöffnung und Labyrinthkanal jeweils umgelenkt wird, was die Gasströmung nicht oder nicht wesentlich beeinträchtigt, während mitgeführte Verunreinigungen aufgrund der höheren Trägheitskräfte abgeschieden werden.

Erfindungsgemäß ist somit die Innenraumöffnung im Bereich eines ersten Umfangsendes des Labyrinthkanals angeordnet, während die Umgebungsöffnung im Bereich eines zweiten Umfangsendes des Labyrinthkanals angeordnet ist. Hierdurch kann im Wesentlichen die gesamte Länge des sich in der Umfangsrichtung erstreckenden Labyrinthkanals für die Abscheidefunktion genutzt werden.

Bei einer Weiterbildung kann nun vorgesehen sein, dass das erste Gehäuseteil im Kontaktbereich einen ersten Randbereich aufweist, der zumindest einen Teil des Labyrinthkanals enthält, während das zweite Gehäuseteil im Kontaktbereich einen zweiten Randbereich aufweist, der axial am ersten Randbereich anliegt. In einer bevorzugten Ausführungsform ist der Labyrinthkanal ausschließlich im ersten Randbereich ausgebildet. Der zweite Randbereich ist dann gegenüber von dem Labyrinthkanal vorzugsweise eben ausgestaltet. Alternativ ist auch eine Ausführungsform denkbar, bei der Labyrinthkanal zum Teil im ersten Randbereich und zum Teil im zweiten Randbereich ausgebildet ist. Jedenfalls kann der Labyrinthkanal im Kontaktbereich quer zur Umfangsrichtung einen Kanalquerschnitt aufweisen, der radial nach innen und radial nach außen vom ersten Randbereich begrenzt ist. Der Kanalquerschnitt ist an einer vom zweiten Randbereich axial abgewandten Seite vom ersten Randbereich begrenzt und an einer dem zweiten Randbereich axial zugewandten Seite vom zweiten Randbereich begrenzt. Mit anderen Worten, bei fehlendem zweitem Gehäuseteil ist der im ersten Randbereich ausgebildete Labyrinthkanal axial einseitig offen. Beim Zusammenbau des Gehäuses wird dann die axial offene Seite des Labyrinthkanals durch den zweiten Randbereich verschlossen. Diese Ausgestaltung hat den Vorteil, dass sich das erste Gehäuseteil und das zweite Gehäuseteil besonders einfach spritzformen lassen, was die Herstellung des Gehäuses preiswert macht.

Die Axialrichtung des Gehäuses ist durch die Montagerichtung definiert, in der die beiden Gehäuseteile aneinander befestigt werden. Sie erstreckt sich regelmäßig senkrecht zu einer Ebene, sogenannte Trennebene, in der die Gehäuseteile aneinander anliegen. Die Axialrichtung erstreckt sich parallel zur Montagerichtung. Die Umfangsrichtung der Stelleinrichtung bzw. des Gehäuses bezieht sich auf die Axialrichtung und läuft um diese um.

Die Axialrichtung der Stelleinrichtung ist durch die Rotationsachse des Elektromotors definiert und erstreckt sich dazu parallel. Zweckmäßig verlaufen die Rotationsache und die Montagerichtung parallel zueinander. Die Umfangsrichtung der Stelleinrichtung bzw. des Gehäuses bezieht sich auf die Axialrichtung und läuft um diese um.

Bei einer anderen Weiterbildung kann der erste Randbereich im Bereich des Druckausgleichslabyrinths doppelwandig ausgestaltet sein, so dass er dort eine dem Innenraum zugewandte Innenwand sowie eine vom Innenraum abgewandte Außenwand aufweist. Zwischen Innenwand und Außenwand ist der Labyrinthkanal ausgebildet. Außerdem begrenzt die Innenwand den Kanalquerschnitt radial nach innen, während die Außenwand den Kanalquerschnitt radial nach außen begrenzt. Durch die doppelwandige Ausführung des ersten Randbereichs entlang des Druckausgleichslabyrinths wird die Herstellung besonders preiswert.

Gemäß einer vorteilhaften Weiterbildung kann der erste Randbereich im Bereich des Druckausgleichslabyrinths einen radial abstehenden Steg aufweisen, der den Kanalquerschnitt an einer vom zweiten Randbereich axial abgewandten Seite begrenzt und von dem die Außenwand ausgeht, wenn er radial nach außen absteht, oder die Innenwand ausgeht, wenn er radial nach innen absteht. Auch diese Maßnahme führt zu einer kompakten und somit preiswerten Lösung.

Eine andere Ausführungsform sieht vor, die Innenraumöffnung in der Innenwand auszubilden. Die Innenraumöffnung ist dabei zweckmäßig radial orientiert. Somit lässt sich die Innenraumöffnung besonders einfach integrieren. Unter der Orientierung einer Öffnung wird im vorliegenden Zusammenhang die Richtung einer Längsmittelachse der jeweiligen Öffnung verstanden, entlang der die Öffnung hauptsächlich durchströmbar ist.

Vorteilhaft ist eine Weiterbildung, bei welcher die Innenraumöffnung radial orientiert ist und axial vom Steg beabstandet ist. Ferner lässt sich die Innenraumöffnung besonders einfach herstellen, wenn sie bei fehlendem zweitem Gehäuseteil axial einseitig offen ist. Diese axiale Beabstandung führt zu einem Querschnittssprung, was die Abscheidewirkung für Verunreinigungen erhöht.

Eine andere Ausführungsform sieht vor, dass am zweiten Randbereich zumindest im Bereich des Druckausgleichslabyrinths ein Innenkragen ausgebildet ist, der im Innenraum radial von der Innenwand beabstandet angeordnet ist, der axial vom übrigen zweiten Randbereich absteht und der die Innenraumöffnung axial überlappt. Durch diesen Innenkragen wird somit eine direkte Einströmung von Luft aus dem Innenraum in die Innenraumöffnung verhindert, vielmehr muss die Luft an dieser Stelle eine weitere Umlenkung durchführen.

Bei einer anderen Ausführungsform kann die Umgebungsöffnung in der Außenwand ausgebildet sein. Insbesondere kann die Umgebungsöffnung dabei radial orientiert sein. Hierdurch lässt sich die Umgebungsöffnung besonders einfach realisieren. Beispielsweise kann die Umgebungsöffnung so hergestellt werden, dass sie bei fehlendem zweitem Gehäuseteil axial einseitig offen ist.

Bei einer vorteilhaften Weiterbildung kann die Umgebungsöffnung radial orientiert sein und axial vom Steg beabstandet sein. Auch hierdurch wird ein Querschnittssprung am Übergang zwischen Umgebungsöffnung und Labyrinthkanal realisiert, was die Abscheidewirkung verbessert.

Eine andere Ausführungsform sieht vor, dass am zweiten Randbereich zumindest im Bereich des Druckausgleichslabyrinths ein Außenkragen ausgebildet ist, der in der Umgebung radial von der Außenwand beabstandet angeordnet ist und dabei vom übrigen zweiten Randbereich axial absteht und die Umgebungsöffnung axial überlappt. Somit wird auch im Bereich der Umgebungsöffnung eine weitere Umlenkung erzwungen, wenn Luft aus der Umgebung in die Umgebungsöffnung eintreten soll.

Bei einer anderen Ausführungsform kann dagegen vorgesehen sein, dass die Umgebungsöffnung im Steg ausgebildet ist. Zweckmäßig ist die Umgebungsöffnung dann axial orientiert.

Bei einer alternativen Ausführungsform kann die Umgebungsöffnung im zweiten Randbereich ausgebildet sein. Auch hier kann die Umgebungsöffnung vorzugsweise axial orientiert sein.

Die Positionierung der Umgebungsöffnung und/oder deren Orientierung bzw. Ausrichtung kann insbesondere abhängig von der jeweiligen Einbausituation der Stelleinrichtung gewählt werden. Zweckmäßig ist die Umgebungsöffnung so angeordnet bzw. orientiert, dass sie im Einbauzustand der Stelleinrichtung vom Labyrinthkanal nach unten, also im Wesentlichen in der Schwerkraftrichtung zur Umgebung führt. Auf diese Weise können Verunreinigungen, die sich im Labyrinthkanal absetzen können, wieder aus dem Druckausgleichslabyrinth in die Umgebung austreten.

Eine andere Ausführungsform sieht vor, dass im Druckausgleichslabyrinth ein Filterelement angeordnet ist. Hierdurch kann der Schutz vor Verunreinigungen besonders effizient gestaltet werden. Ein derartiges Filterelement kann beispielsweise durch ein typisches Filtermaterial gebildet werden, zum Beispiel aus einem Vlies, das für Gas durchlässig und für die störenden Verunreinigungen undurchlässig ist. Die Anordnung des Filterelements im Druckausgleichslabyrinth erfolgt zweckmäßig derart, dass ein im Druckausgleichslabyrinth ausgebildeter, den Innenraum mit der Umgebung fluidisch verbindender Druckausgleichspfad durch das Filterelement hindurchführt. Auf diese Weise ist jegliche Gasströmung, die sich zum Druckausgleich zwischen Innenraum und Umgebung durch das Druckausgleichslabyrinth entlang des Druckausgleichspfads ausbildet, gezwungen, vollständig durch das Filterelement zu strömen. Zusätzlich oder alternativ kann vorgesehen sein, dass im Druckausgleichslabyrinth eine gasdurchlässige Membran angeordnet ist. Auch diese Membran, die beispielsweise aus PTFE (Polytetrafluorethylen) bestehen kann, ist im Druckausgleichslabyrinth so angeordnet, dass jegliches Gas, das zum Druckausgleich zwischen der Umgebung und dem Innenraum ausgetauscht werden soll, die Membran durchdringen muss. Ebenso ist denkbar, das Filterelement als gasdurchlässige Membran auszugestalten.

Zweckmäßig kann vorgesehen sein, dass das eine Gehäuseteil einen Topf bildet und einen wesentlichen Anteil des Innenraums enthält, während das andere Gehäuseteil einen Deckel bildet, um den Topf zu verschließen. Vorzugsweise ist das erste Gehäuseteil als Topf ausgestaltet, während das zweite Gehäuseteil als Deckel ausgestaltet ist. Besonders vorteilhaft ist eine Ausführungsform, bei der beide Gehäuseteile aus Kunststoff hergestellt sind. Im Kontaktbereich können die Gehäuseteile miteinander verklebt oder verschweißt sein oder durch Plastifizieren eines der Gehäuseteile miteinander fest verbunden sein. Während beim Schweißen beide Verbindungspartner aufgeschmolzen werden, reicht es beim Plastifizieren aus, nur einen der Verbindungspartner aufzuschmelzen. Die Schmelze wirkt dann einerseits wie ein Klebstoff und kann andererseits auch Fusionsverbindungen mit dem anderen Verbindungspartner erzeugen.

Zweckmäßig erstreckt sich der Kontaktbereich in einer Ebene, die als Teilungsebene oder Trennebene des Gehäuses bezeichnet werden kann.

Eine erfindungsgemäße Steuereinrichtung weist wenigstens ein elektrisches und/oder elektronisches Element auf und ist mit einem Gehäuse der vorstehend beschriebenen Art ausgestattet. Dabei ist das jeweilige elektrische und/oder elektronische Element im Innenraum des Gehäuses angeordnet. Die Steuereinrichtung kann beispielsweise zum Ansteuern eines Elektromotors dienen, vorzugsweise eines bürstenlosen Gleichstrommotors, also eines BLDC-Motors, wobei BLDC für *"brushless direct current"* steht. Üblicherweise umfasst die Steuereinrichtung eine Vielzahl an elektrischen und/oder elektronischen Elementen. Typische elektronische und/oder elektrische Elemente der Steuereinrichtung sind bzw. bilden eine Leistungselektronik und/oder eine Sensorik, z.B. zur aktuellen Drehlagenbestimmung des Elektromotors bzw. eines damit angetriebenen Stellglieds.

Eine erfindungsgemäße Stelleinrichtung dient zum mechanischen Betätigen einer Komponente einer Maschine, vorzugsweise einer Brennkraftmaschine, und umfasst eine Elektromotor zum Antreiben eines Stellglieds, das zum Koppeln mit der zu betätigenden Komponente dient, sowie eine Steuereinrichtung der vorstehend beschriebenen Art, die zum Ansteuern des Elektromotors dient. Besonders vorteilhaft ist dabei eine Ausführungsform, bei welcher der Elektromotor wie das jeweilige elektrische und/oder elektronische Element der Steuereinrichtung im Innenraum des Gehäuses angeordnet ist. Ferner kann zweckmäßig das Stellglied außen am Gehäuse angeordnet sein.

Eine andere erfindungsgemäße Stelleinrichtung dient ebenfalls zum mechanischen Betätigen einer Komponente einer Maschine, vorzugsweise einer Brennkraftmaschine, und ist selbst mit einem Gehäuse der vorstehend beschriebenen Art ausgestattet. Ferner umfasst die Stelleinrichtung einen im Innenraum des Gehäuses angeordneten Elektromotor, der zum Antreiben eines außen am Gehäuse angeordneten Stellglieds dient, das seinerseits zum Koppeln mit der zu betätigenden Komponente vorgesehen ist.

Eine erfindungsgemäße Maschine, die mit einer Stelleinrichtung der vorstehend beschriebenen Art ausgestattet ist, kann beispielsweise durch einen Abgasturbolader oder durch eine Abgasrückführanlage gebildet sein. Die mit Hilfe der Stelleinrichtung zu betätigende Komponente der jeweiligen Maschine kann bei einer als Abgasturbolader ausgestalteten Maschine durch eine variable Turbinengeometrie oder durch ein Wastegateventil gebildet sein. Bei einer als Abgasrückführanlage ausgestalteten Maschine kann es sich bei der mit Hilfe der Stelleinrichtung zu betätigenden Komponente um ein Abgasrückführventil zum Einstellen einer Abgasrückrate handeln.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch
- Fig. 1: eine isometrische Ansicht einer Stelleinrichtung,
- Fig. 2: ein vergrößertes Detail II aus Fig. 1 eines ersten Gehäuseteils bei fehlendem zweitem Gehäuseteil,
- Fig. 3: eine Schnittansicht entsprechend Schnittlinien III in Fig. 2 im Bereich eines Labyrinthkanals eines Druckausgleichslabyrinths,
- Fig. 4: eine Schnittansicht entsprechend Schnittlinien IV in Fig. 2 im Bereich einer Umgebungsöffnung des Druckausgleichslabyrinths,
- Fig. 5: eine Schnittansicht entsprechend Schnittlinien V in Fig. 2 im Bereich einer Innenraumöffnung des Druckausgleichslabyrinths,
- Fig. 6: eine Draufsicht auf das erste Gehäuseteil im Bereich des Druckausgleichslabyrinths, bei einer anderen Ausführungsform,
- Fig. 7: eine isometrische Ansicht wie in Fig. 2, jedoch mit dem zweiten Gehäuseteil, bei einer weiteren Ausführungsform,
- Fig. 8: eine isometrische Ansicht des zweiten Gehäuseteils aus Fig. 7 im Bereich des Druckausgleichslabyrinths,
- Fig. 9: ein Querschnitt wie in Fig. 3, jedoch bei einer anderen Ausführungsform.

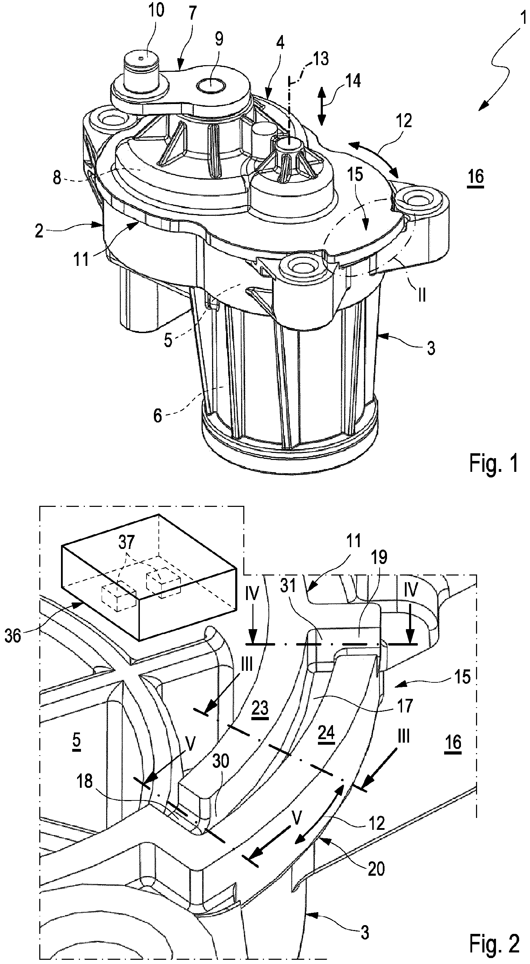

Entsprechend Fig. 1 umfasst eine Stelleinrichtung 1, die zum mechanischen Betätigen einer hier nicht gezeigten Komponente einer hier ebenfalls nicht gezeigten Maschine geeignet und bestimmt ist, ein Gehäuse 2, das ein erstes Gehäuseteil 3 und ein zweites Gehäuseteil 4 aufweist. Im Gehäuse 2 ist ein Innenraum 5 enthalten, in dem ein Elektromotor 6 angeordnet ist. Dieser Elektromotor 6 ist dabei antriebsmäßig mit einem Stellglied 7 gekoppelt, das sich außen am Gehäuse 2 befindet. Beispielsweise kann im Gehäuse 2 bzw. im Innenraum 5 ein Getriebe 8 angeordnet sein, das eine Antriebswelle des Elektromotors 6 mit einer aus dem Gehäuse 2 herausgeführten Welle 9 antriebsmäßig verbindet, an welcher das Stellglied 7 drehfest angebracht ist. Das Stellglied 7 trägt außerdem einen Zapfen 10, der so ausgestaltet ist, dass er mit derjenigen Komponente gekoppelt werden kann, die mit Hilfe der Stelleinrichtung 1 mechanisch betätigt werden soll.

Im Beispiel der Fig. 1 ist das erste Gehäuseteil 3 topfförmig ausgestaltet und enthält einen wesentlichen Bestandteil, also mehr als 50%, im Beispiel mehr als 75% des Volumens des Innenraums 5. Im Unterschied dazu ist das zweite Gehäuseteil 4 hier als Deckel ausgestaltet, der im montierten Zustand den durch das erste Gehäuseteil 3 gebildeten Topf verschließt. Somit ist der Innenraum 5 von den beiden Gehäuseteilen 3, 4 vollständig eingefasst. Grundsätzlich sind jedoch auch andere Formen für die Gehäuseteile 3, 4 denkbar. Die beiden Gehäuseteile 3, 4 sind hier jeweils einteilig ausgestaltet. Ebenso ist denkbar, zumindest eines der Gehäuseteile 3, 4 mehrteilig auszugestalten.

Jedenfalls handelt es sich bei den beiden Gehäuseteilen 3, 4 um separate Bauteile, die im montierten Zustand des Gehäuses 2 aneinander befestigt sind und die in einem Kontaktbereich 11 aneinander anliegen. Dieser Kontaktbereich 11 läuft in einer Umfangsrichtung 12 des Gehäuses 2 entlang des Innenraums 5 geschlossen um. Die Umfangsrichtung 12 bezieht sich auf eine Rotationsachse 13 des Elektromotors 6. Diese Rotationsachse 13 definiert außerdem eine Axialrichtung 14, die parallel zur Rotationsachse 13 verläuft. Im Beispiel erstreckt sich der Kontaktbereich 11 im Wesentlichen in einer Ebene, die auch als Trennebene bezeichnet werden kann. Zweckmäßig verläuft die Axialrichtung 14 senkrecht zu dieser Trennebene. Zum Schließen des Gehäuses 2 werden die beiden Gehäuseteile 3, 4 zweckmäßig axial aneinander angebracht, so dass eine Montagerichtung des Gehäuses 2 parallel zur Axialrichtung 14 verläuft.

In Fig. 2 ist eine Steuereinrichtung 36 angedeutet, die ebenfalls im Innenraum 5 des Gehäuses 2 untergebracht ist. Diese Steuereinrichtung 36 dient zum Ansteuern des Elektromotors 6 und weist mehrere elektrische und/oder elektronische Elemente 37 auf, die beispielsweise eine Sensorik und/oder eine Leistungselektronik bilden können.

Im Kontaktbereich 11 ist ein Druckausgleichslabyrinth 15 ausgebildet, das den Innenraum 5 fluidisch mit einer Umgebung 16 des Gehäuses 2 verbindet. Nachfolgend wird anhand der Fig. 2 bis 9 näher auf dieses Druckausgleichslabyrinth 15 eingegangen.

Entsprechend den Fig. 2 bis 9 besitzt das Druckausgleichslabyrinth 15 einen Labyrinthkanal 17, eine Innenraumöffnung 18 und eine Umgebungsöffnung 19. Der Labyrinthkanal 17 erstreckt sich in der Umfangsrichtung 12 entlang eines Teils des Kontaktbereichs 11. Im gezeigten Beispiel erstreckt sich der Labyrinthkanal über weniger als 20% des Kontaktbereichs 11. Die Innenraumöffnung 18 steht mit dem Innenraum 5 fluidisch in Verbindung. Die Umgebungsöffnung 19 steht mit der Umgebung 16 fluidisch in Verbindung. Der Labyrinthkanal 17 verbindet die Innenraumöffnung 18 fluidisch mit der Umgebungsöffnung 19, so dass letztlich der Labyrinthkanal 17 über die Innenraumöffnung 18 mit dem Innenraum 5 und über die Umgebungsöffnung 19 mit der Umgebung 16 jeweils fluidisch verbunden ist. Bemerkenswert ist ferner, dass die Innenraumöffnung 18 und die Umgebungsöffnung 19 in der Umfangsrichtung 12 zueinander versetzt angeordnet sind.

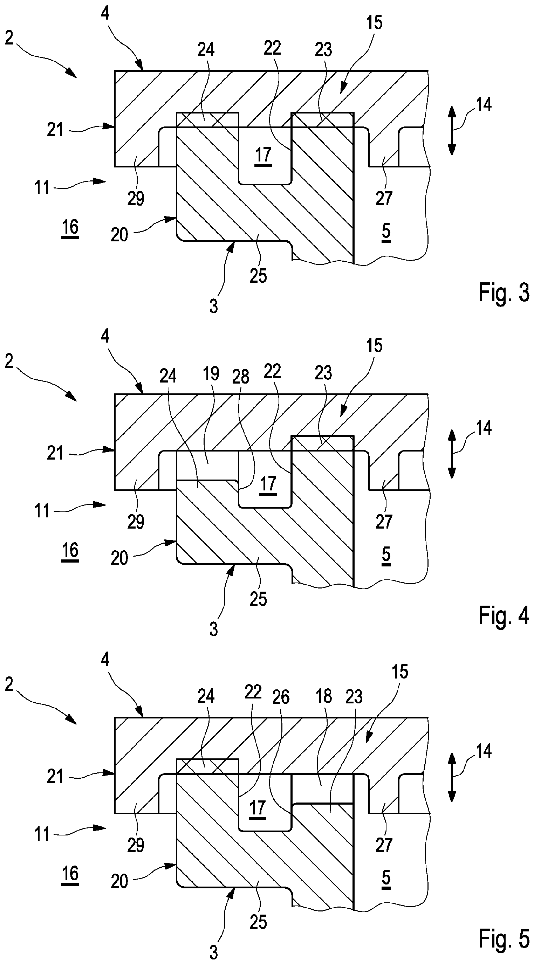

Das erste Gehäuseteil 3 weist im Kontaktbereich 11 einen ersten Randbereich 20 auf, in dem der Labyrinthkanal 17 ausgebildet ist. Das zweite Gehäuseteil 4 weist im Kontaktbereich 11 einen zweiten Randbereich 21 auf. Der zweite Randbereich 21 liegt axial am ersten Randbereich 20 an. In den Schnittansichten der Fig. 3 bis 5 und 9 dringt der erste Randbereich 20 scheinbar in den zweiten Randbereich 21 axial ein. Dies dient lediglich zur Andeutung einer Verbindung durch Verschweißen oder Plastifizieren zwischen erstem Randbereich 20 und zweitem Randbereich 21, bei der bevorzugt zumindest eine axiale Stirnseite des ersten Randbereichs 20 aufgeheizt wird. Im gezeigten bevorzugten Beispiel ist der Labyrinthkanal 17 ausschließlich bzw. vollständig im ersten Randbereich 20 ausgebildet und durch den vorzugsweise ebenen zweiten Randbereich 21 nur verschlossen. Bei einer nicht gezeigten anderen Ausführungsform kann dagegen vorgesehen sein, dass der Labyrinthkanal 17 teilweise im ersten Randbereich 20 und teilweise im zweiten Randbereich 21 ausgebildet ist. Die beiden Teilbereiche des Labyrinthkanals 17 sind dann an einander zugewandten Seiten jeweils einseitig offen. In diesem Fall wird erst beim Zusammenbau der Gehäuseteile 3, 4 der Labyrinthkanal 17 komplettiert und dabei gleichzeitig auch seitlich verschlossen.

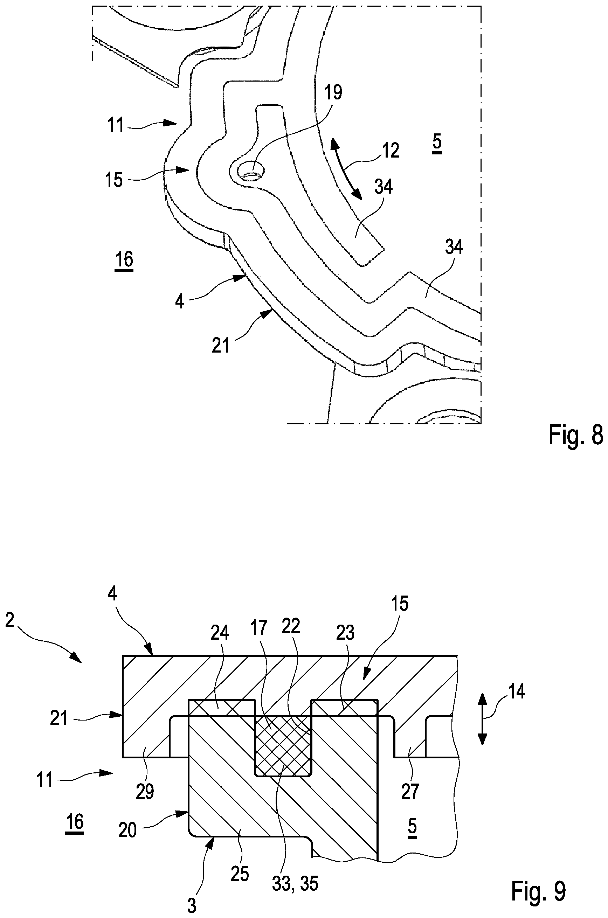

Wie sich insbesondere den Fig. 3 und 9 entnehmen lässt, besitzt der Labyrinthkanal 17 im Kontaktbereich 11 quer zur Umfangsrichtung 12, die in den Schnittansichten der Fig. 3 bis 5 und 9 senkrecht zur Zeichnungsebene verläuft, einen Kanalquerschnitt 22, der radial innen und radial außen vom ersten Randbereich 20 begrenzt ist. Ferner ist dieser Kanalquerschnitt 22 axial vom zweiten Randbereich 21 abgewandt, ebenfalls vom ersten Randbereich 20 begrenzt. Dem zweiten Randbereich 21 axial zugewandt ist der Kanalquerschnitt 22 dagegen vom zweiten Randbereich 21 begrenzt. Bei fehlendem zweitem Gehäuseteil 4 ist der Kanalquerschnitt 22 bzw. der Labyrinthkanal 17 somit axial einseitig offen. Bei angebrachtem zweitem Gehäuseteil 4 ist diese axial offene Seite des Labyrinthkanals 17 durch den zweiten Randbereich 21 axial verschlossen.

Wie sich den Fig. 2 bis 6 und 9 entnehmen lässt, ist der erste Randbereich 20 zumindest im Bereich des Druckausgleichslabyrinths 15 doppelwandig ausgestaltet, wobei er eine dem Innenraum 5 zugewandte Innenwand 23 und eine vom Innenraum 5 abgewandte Außenwand 24 aufweist. Zwischen Innenwand 23 und Außenwand 24 erstreckt sich der Labyrinthkanal 17. Ferner bilden Innenwand 23 und Außenwand 24 die radiale Begrenzung des Kanalquerschnitts 22 am ersten Randbereich 20. Beim hier gezeigten, bevorzugten Beispiel ist der erste Randbereich 20 ausschließlich im Bereich des Druckausgleichslabyrinths 15 doppelwandig ausgestaltet.

Wie sich insbesondere den Fig. 3 und 9 entnehmen lässt, weist der erste Randbereich 20 im Bereich des Druckausgleichslabyrinths 15, vorzugsweise ausschließlich im Bereich des Druckausgleichslabyrinths 15, einen radial abstehenden Steg 25 auf, der den Kanalquerschnitt 22 axial vom zweiten Randbereich 21 abgewandt begrenzt. Im hier gezeigten, bevorzugten Beispiel steht der Steg 25 radial nach außen ab. Demnach geht im Beispiel die Außenwand 24 von diesem Steg 25 aus. Letztlich verbindet der Steg 25 die Innenwand 23 mit der Außenwand 24.

Bei allen hier gezeigten Ausführungsformen ist die Innenraumöffnung 18 in der Innenwand 23 ausgebildet und außerdem radial orientiert. Ferner lässt sich zumindest Fig. 5 entnehmen, dass die Innenraumöffnung 18 vom Steg 25 axial beabstandet ist. Dementsprechend befindet sich im Labyrinthkanal 17 am Übergang zur Innenraumöffnung 18 eine Stufe 26.

Gemäß den Fig. 3 bis 5 und 7 kann am zweiten Randbereich 21 zumindest im Bereich des Druckausgleichslabyrinths 15 ein Innenkragen 27 ausgebildet sein. Der Innenkragen 27 steht im Innenraum 5 radial von der Innenwand 23 beabstandet axial ab und überlappt dabei die Innenraumöffnung 18 axial. Die axiale Überlappung der Innenraumöffnung 18 durch die Innenwand 27 ist in Fig. 5 erkennbar.

In den Beispielen der Fig. 2 bis 5 ist die Umgebungsöffnung 19 in der Außenwand 24 ausgebildet und zweckmäßig radial orientiert. Gemäß Fig. 4 kann dabei die Umgebungsöffnung 19 zweckmäßig so angeordnet sein, dass sie vom Steg 25 axial beabstandet ist. Somit entsteht im Labyrinthkanal 17 am Übergang zur Umgebungsöffnung 19 ebenfalls eine Stufe 28. Ferner besitzt der zweite Randbereich 21 zumindest im Bereich des Druckausgleichslabyrinths 15 einen Außenkragen 29. Der Außenkragen 29 steht dabei in der Umgebung 16 axial ab und ist dabei radial von der Außenwand 24 beabstandet. Ferner überlappt der Außenkragen 29 die Umgebungsöffnung 19 axial. Diese axiale Überlappung ist in Fig. 4 erkennbar.

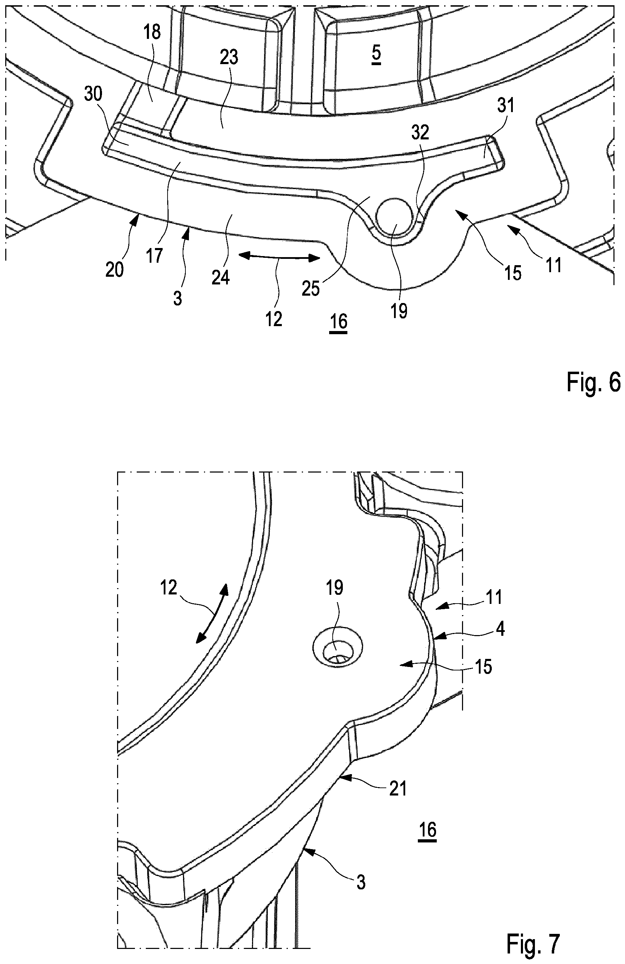

Fig. 6 zeigt eine andere Ausführungsform, bei der die Umgebungsöffnung 19 im Steg 25 ausgebildet ist und dabei axial orientiert ist. In Fig. 6 ist die Axialrichtung senkrecht zur Zeichnungsebene orientiert. Die Fig. 7 und 8 zeigen eine weitere alternative Ausführungsform, bei der die Umgebungsöffnung 19 im zweiten Randbereich 21 ausgebildet ist und ebenfalls zweckmäßig axial orientiert ist. In Fig. 8 sind der Innenkragen 27 und der Außenkragen 28 nicht dargestellt bzw. nicht vorhanden. Dafür ist in Fig. 8 eine Verbindungszone 34 angedeutet, in der die Verbindung der beiden Randbereiche 20, 21 aneinander mittels Klebens, Schweißens oder Plastifizierens stattfindet.

Die Fig. 2 bis 5 zeigen ein Beispiel, bei dem die Innenraumöffnung 18 im Bereich eines ersten Umfangsendes 30 des Labyrinthkanals 17 angeordnet ist, während die Umgebungsöffnung 19 im Bereich eines zweiten Umfangsendes 31 des Labyrinthkanals 17 angeordnet ist. Hierdurch wird die gesamte Länge des Labyrinthkanals 17 ausgenutzt, die sich in der Umfangsrichtung 12 erstreckt. Ferner ist bei diesem Beispiel vorgesehen, dass der Labyrinthkanal 17 zwischen der Innenraumöffnung 18 und der Umgebungsöffnung19 entlang seiner Erstreckung in der Umfangsrichtung 12 einen im Wesentlichen gleichbleibenden Kanalquerschnitt 22 besitzt.

Im Unterschied dazu zeigen die Fig. 6 bis 8 Beispiele, bei denen der Labyrinthkanal 17 zwischen seinen beiden Umfangsenden 30, 31 eine radial orientierte Ausbuchtung 32 aufweist. Im Bereich dieser Ausbuchtung 32 ist der Kanalquerschnitt 22 radial vergrößert. Die Ausbuchtung 32 ist bei den hier gezeigten Beispielen radial nach außen orientiert. Ferner ist bei den hier gezeigten Beispielen vorgesehen, dass die Umgebungsöffnung 19 im Bereich dieser Ausbuchtung 32 positioniert ist und dabei axial orientiert ist. In Fig. 6 ist die Umgebungsöffnung 19 im Bereich der Ausbuchtung 12 bzw. innerhalb der Ausbuchtung 12 am ersten Randbereich 20, nämlich im Steg 25, ausgebildet. Im Beispiel der Fig. 7 und 8 ist die Umgebungsöffnung 19 im Bereich der Ausbuchtung 32 bzw. in der Ausbuchtung 32 am zweiten Randbereich 21 ausgebildet.

Fig. 9 zeigt rein exemplarisch ein Beispiel für eine besondere Ausführungsform, bei der im Druckausgleichslabyrinth 15 ein Filterelement 33 angeordnet ist. Dabei füllt das Filterelement 33 den gesamten Kanalquerschnitt 22 aus, so dass ein nicht näher bezeichneter Druckausgleichspfad, der im Druckausgleichslabyrinth 15 ausgebildet ist und der den Innenraum 5 mit der Umgebung 16 fluidisch verbindet, durch dieses Filterelement 33 führt. Das Filterelement 33 kann gemäß einer vorteilhaften Ausführungsform als gasdurchlässige Membran 35 ausgestaltet sein. Ebenso ist denkbar eine separate gasdurchlässige Membran 35 zusätzlich oder alternativ zum Filterelement 33 vorzusehen.

## Patentansprüche

1. Gehäuse (2) einer elektrischen und/oder elektronischen Komponente (1),
- mit einem ersten Gehäuseteil (3), einem zweiten Gehäuseteil (4) und einem Innenraum (5) zur Aufnahme wenigstens eines elektrischen und/oder elektronischen Elements (37),
- wobei die beiden Gehäuseteile (3, 4) aneinander befestigt sind und in einem Kontaktbereich (11) aneinander anliegen, der in einer Umfangsrichtung (12) des Gehäuses (2) entlang des Innenraums (5) geschlossen umläuft,
- wobei im Kontaktbereich (11) ein Druckausgleichslabyrinth (15) ausgebildet ist, das den Innenraum (5) fluidisch mit einer Umgebung (16) des Gehäuses (2) verbindet,
- wobei das Druckausgleichslabyrinth (15) einen Labyrinthkanal (17) aufweist, der sich in der Umfangsrichtung (12) des Kontaktbereichs (11) erstreckt, der über eine Innenraumöffnung (18) mit dem Innenraum (5) fluidisch verbunden ist und der über eine Umgebungsöffnung (19) mit der Umgebung (16) fluidisch verbunden ist, die in der Umfangsrichtung (12) zur Innenraumöffnung (18) versetzt angeordnet ist,
**dadurch gekennzeichnet,**
- **dass** sich der Labyrinthkanal (17) in der Umfangsrichtung (12) nur entlang eines Teils des Kontaktbereichs (11) zwischen einem ersten Umfangsende (30) und einem zweiten Umfangsende (31) erstreckt,
- **dass** die Innenraumöffnung (18) im Bereich des ersten Umfangsendes (30) des Labyrinthkanals (17) angeordnet ist, während die Umgebungsöffnung (19) im Bereich des zweiten Umfangsendes (31) des Labyrinthkanals (17) angeordnet ist.

2. Gehäuse nach Anspruch 1,
**dadurch gekennzeichnet,**
**dass** sich der Labyrinthkanal (17) in der Umfangsrichtung (12) über weniger als 20% des Kontaktbereichs (11) erstreckt.

3. Gehäuse (2) nach einem der vorhergehenden Ansprüche,
**dadurch gekennzeichnet,**
- **dass** das erste Gehäuseteil (2) im Kontaktbereich (11) einen ersten Randbereich (20) aufweist, der zumindest einen Teil des Labyrinthkanals (17) enthält,
- **dass** das zweite Gehäuseteil (4) im Kontaktbereich (11) einen zweiten Randbereich (21) aufweist, der axial am ersten Randbereich (20) anliegt,
- **dass** der Labyrinthkanal (17) im Kontaktbereich (11) quer zur Umfangsrichtung (12) einen Kanalquerschnitt (22) aufweist, der radial innen und radial außen vom ersten Randbereich (20) begrenzt ist, der an einer vom zweiten Randbereich (21) abgewandten Seite vom ersten Randbereich (20) axial begrenzt ist und der an einer dem zweiten Randbereich (21) zugewandten Seite vom zweiten Randbereich (21) axial begrenzt ist.

4. Gehäuse (2) nach Anspruch 3,
**dadurch gekennzeichnet,**
**dass** der erste Randbereich (20) im Bereich des Druckausgleichslabyrinths (15) doppelwandig ausgestaltet ist und eine dem Innenraum (5) zugewandte Innenwand (23) sowie eine vom Innenraum (5) abgewandte Außenwand (24) aufweist, zwischen denen der Labyrinthkanal (17) ausgebildet ist.

5. Gehäuse (2) nach Anspruch 4,
**dadurch gekennzeichnet,**
**dass** der erste Randbereich (20) im Bereich des Druckausgleichslabyrinths (15) einen radial abstehenden Steg (25) aufweist, der den Kanalquerschnitt (22) gegenüber vom zweiten Randbereich (21) axial begrenzt und von dem die Außenwand (24) oder die Innenwand (23) ausgeht.

6. Gehäuse (2) nach Anspruch 4 oder 5,
**dadurch gekennzeichnet,**
**dass** die Umgebungsöffnung (19) in der Außenwand (24) ausgebildet ist.

7. Gehäuse (2) nach den Ansprüchen 5 und 6,
**dadurch gekennzeichnet,**
**dass** die Umgebungsöffnung (19) radial orientiert ist und axial vom Steg (25) beabstandet ist.

8. Gehäuse (2) nach Anspruch 6 oder 7,
**dadurch gekennzeichnet,**
**dass** am zweiten Randbereich (21) zumindest im Bereich des Druckausgleichslabyrinths (15) ein Außenkragen (29) ausgebildet ist, der in der Umgebung (16) axial absteht, radial von der Außenwand (29) beabstandet ist und die Umgebungsöffnung (19) axial überlappt.

9. Gehäuse (2) nach einem der Ansprüche 1 bis 8,
**dadurch gekennzeichnet,**
- **dass** die Umgebungsöffnung (19) im Steg (25) nach Anspruch 6 ausgebildet ist, und/oder
- **dass** die Umgebungsöffnung (19) im zweiten Randbereich (21) nach Anspruch 4 ausgebildet ist.

10. Gehäuse (2) nach einem der Ansprüche 1 bis 9,
**dadurch gekennzeichnet,**
- **dass** im Druckausgleichslabyrinth (15) ein Filterelement (33) und/oder eine gasdurchlässige Membran (35) angeordnet ist, oder
- **dass** im Druckausgleichslabyrinth (15) ein als gasdurchlässige Membran (35) ausgestaltetes Filterelement (33) angeordnet ist.

11. Gehäuse (2) nach einem der vorhergehenden Ansprüche,
**dadurch gekennzeichnet,**
**dass** der Labyrinthkanal (17) zwischen seinen Umfangsenden (30, 31) eine radiale Ausbuchtung (32) aufweist.

12. Steuereinrichtung (36) mit wenigstens einem elektrischen und/oder elektronischen Element (37) und mit einem Gehäuse (2) nach einem der vorhergehenden Ansprüche, wobei das jeweilige elektrische und/oder elektronische Element (37) im Innenraum (5) des Gehäuses (2) angeordnet ist.

13. Stelleinrichtung (1) zum mechanischen Betätigen einer Komponente einer Maschine, vorzugsweise einer Brennkraftmaschine,
- mit einem Elektromotor (6) zum Antreiben eines Stellglieds (7) zum Koppeln mit der zu betätigenden Komponente, und
- mit einer Steuereinrichtung (36) nach Anspruch 12 zum Ansteuern des Elektromotors (6),
- wobei insbesondere vorgesehen sein kann, dass der Elektromotor (6) im Innenraum (5) des Gehäuses (2) angeordnet ist und dass das Stellglied (7) außen am Gehäuse (2) angeordnet ist.

14. Stelleinrichtung (1) zum mechanischen Betätigen einer Komponente einer Maschine, vorzugsweise einer Brennkraftmaschine,
- mit einem Gehäuse (2) nach einem der Ansprüche 1 bis 12,
- mit einem im Innenraum (5) des Gehäuses (2) angeordneten Elektromotor (6) zum Antreiben eines außen am Gehäuse (2) angeordneten Stellglieds (7) zum Koppeln mit der zu betätigenden Komponente.

## Claims

1. Housing (2) of an electrical and/or electronic component (1),
- comprising a first housing part (3), a second housing part (4) and an interior (5) for receiving at least one electrical and/or electronic element (37),
- wherein the two housing parts (3, 4) are fastened to one another and bear against one another in a contact area (11) which runs around in a closed manner along the interior (5) in a circumferential direction (12) of the housing (2),
- wherein a pressure compensation labyrinth (15) is formed in the contact area (11), which fluidically connects the interior (5) with a surroundings (16) of the housing (2),
- wherein the pressure compensation labyrinth (15) has a labyrinth channel (17), which extends in the circumferential direction (12) of the contact area (11), which is fluidically connected to the interior (5) via an interior opening (18) and which is fluidically connected to the surroundings (16) via an opening to the surroundings (19), which is arranged offset to the interior opening (18) in the circumferential direction (12),
**characterised**
- **in that** the labyrinth channel (17) extends in the circumferential direction (12) only along part of the contact area (11) between a first circumferential end (30) and a second circumferential end (31),
- **in that** the interior opening (18) is arranged in the area of the first circumferential end (30) of the labyrinth channel (17), while the opening to the surroundings (19) is arranged in the area of the second circumferential end (31) of the labyrinth channel (17).

2. Housing according to claim 1,
**characterised**
**in that** the labyrinth channel (17) extends in the circumferential direction (12) over less than 20% of the contact area (11).

3. Housing (2) according to any of the preceding claims,
**characterised**
- **in that** the first housing part (2) in the contact area (11) has a first edge area (20) which contains at least part of the labyrinth channel (17),
- **in that** the second housing part (4) in the contact area (11) has a second edge area (21) which rests axially on the first edge area (20),
- **in that** the labyrinth channel (17) has a channel cross-section (22) in the contact area (11), transverse to the circumferential direction (12), which is bounded radially inside and radially outside by the first edge area (20), which is axially bounded by the first edge area (20) on a side facing away from the second edge area (21) and which is axially bounded by the second edge area (21) on a side facing the second edge area (21).

4. Housing (2) according to claim 3,
**characterised**
**in that** the first edge area (20) in the area of the pressure compensation labyrinth (15) is designed to be double-walled and has an inner wall (23) facing the interior (5) and an outer wall (24) facing away from the interior (5), between which the labyrinth channel (17) is formed.

5. Housing (2) according to claim 4,
**characterised**
**in that** the first edge area (20) in the area of the pressure compensation labyrinth (15) has a radially projecting web (25), which axially bounds the channel cross-section (22) opposite the second edge area (21) and from which the outer wall (24) or the inner wall (23) extends.

6. Housing (2) according to claim 4 or 5,
**characterised**
**in that** the opening to the surroundings (19) is formed in the outer wall (24).

7. Housing (2) according to claims 5 and 6,
**characterised**
**in that** the opening to the surroundings (19) is oriented radially and is axially spaced apart from the web (25).

8. Housing (2) according to claim 6 or 7,
**characterised**
**in that** on the second edge area (21), at least in the area of the pressure compensation labyrinth (15), an outer collar (29) is formed which protrudes axially in the surroundings (16), is radially spaced apart from the outer wall (29) and axially overlaps the opening to the surroundings (19).

9. Housing (2) according to any one of claims 1 to 8,
**characterised**
- **in that** the opening to the surroundings (19) is formed in the web (25) according to claim 6, and/or
- **in that** the opening to the surroundings (19) is formed in the second edge area (21) according to claim 4.

10. Housing (2) according to any one of claims 1 to 9,
**characterised**
- **in that** a filter element (33) and/or a gas-permeable membrane (35) is arranged in the pressure compensation labyrinth (15), or
- **in that** a filter element (33) designed as a gas-permeable membrane (35) is arranged in the pressure compensation labyrinth (15).

11. Housing (2) according to any of the preceding claims,
**characterised**
**in that** the labyrinth channel (17) has a radial bulge (32) between its circumferential ends (30, 31).

12. Control device (36) having at least one electrical and/or electronic element (37) and having a housing (2) according to any one of the preceding claims, wherein the respective electrical and/or electronic element (37) is arranged in the interior (5) of the housing (2).

13. Regulating unit (1) for mechanically actuating a component of an engine, preferably an internal combustion engine,
- having an electric motor (6) for driving an actuator (7) for coupling with the component to be actuated, and
- having a control device (36) according to claim 12 for controlling the electric motor (6),
- wherein it can be provided in particular that the electric motor (6) is arranged in the interior (5) of the housing (2) and that the actuator (7) is arranged on the outside of the housing (2).

14. Regulating unit (1) for mechanically actuating a component of an engine, preferably an internal combustion engine,
- having a housing (2) according to any one of claims 1 to 12,
- having an electric motor (6) arranged in the interior (5) of the housing (2) for driving an actuator (7) arranged on the outside of the housing (2) for coupling to the component to be actuated.

## Revendications

1. Carter (2) d'un composant électrique et/ou électronique (1),
- avec une première partie de carter (3), une seconde partie de carter (4) et un espace intérieur (5) pour recevoir au moins un élément électrique et/ou électronique (37),
- dans lequel les deux parties de carter (3, 4) sont fixées l'une à l'autre et reposent l'une contre l'autre dans une zone de contact (11) qui fait le tour dans une direction périphérique (12) du carter (2) le long de l'espace intérieur (5) de manière fermée,
- dans lequel un labyrinthe de compensation de pression (15) est formé dans la zone de contact (11), qui connecte l'espace intérieur (5) par voie fluidique à un environnement (16) du carter (2),
- dans lequel le labyrinthe de compensation de pression (15) présente un canal de labyrinthe (17) qui s'étend dans la direction périphérique (12) de la surface de contact (11), qui est connectée par voie fluidique à l'espace intérieur (5) par une ouverture d'espace intérieur (18) et qui est connectée par voie fluidique à l'environnement (16) par une ouverture d'environnement (19), qui est disposée décalée par rapport à l'ouverture d'espace intérieur (18) dans la direction périphérique (12),
**caractérisé en ce**
- **que** le canal en labyrinthe (17) s'étend dans la direction périphérique (12) uniquement le long d'une partie de la zone de contact (11) entre une première extrémité périphérique (30) et une seconde extrémité périphérique (31),
- **que** l'ouverture d'espace intérieur (18) est disposée au niveau de la première extrémité périphérique (30) du canal de labyrinthe (17), tandis que l'ouverture d'environnement (19) est disposée au niveau de la seconde extrémité périphérique (31) du canal de labyrinthe (17).

2. Carter selon la revendication 1,
**caractérisé en ce**
**que** le canal de labyrinthe (17) s'étend dans la direction périphérique (12) sur moins de 20 % de la surface de contact (11).

3. Carter (2) selon l'une quelconque des revendications précédentes,
**caractérisé en ce**
- **que** la première partie de carter (2) présente, dans la zone de contact (11), une première zone de bord (20) qui contient au moins une partie du canal de labyrinthe (17),
- **que** la seconde partie de carter (4) présente, dans la zone de contact (11), une seconde zone de bord (21) qui repose axialement contre la première zone de bord (20),
- **que** le canal de labyrinthe (17) présente, dans la zone de contact (11), transversalement à la direction périphérique (12), une section transversale de canal (22) qui est limitée radialement à l'intérieur et radialement à l'extérieur par la première zone de bord (20), qui est limitée axialement par la première zone de bord (20) sur un côté opposé à la seconde zone de bord (21) et qui est limitée axialement par la seconde zone de bord (21) sur un côté tourné vers la seconde zone de bord (21).

4. Carter (2) selon la revendication 3,
**caractérisé en ce**
**que** la première zone de bord (20) au niveau du labyrinthe de compensation de pression (15) est conçue à double paroi et présente une paroi intérieure (23) tournée vers l'espace intérieur (5) et une paroi extérieure (24) opposée à l'espace intérieur (5), entre lesquelles le canal de labyrinthe (17) est formé.

5. Carter (2) selon la revendication 4,
**caractérisé en ce**
**que** la première zone de bord (20) présente, au niveau du labyrinthe de compensation de pression (15), une nervure (25) faisant saillie radialement, qui limite axialement la section transversale de canal (22) opposée à la seconde zone de bord (21) et à partir de laquelle la paroi extérieure (24) ou la paroi intérieure (23) s'étend.

6. Carter (2) selon la revendication 4 ou 5,
**caractérisé en ce**
**que** l'ouverture d'environnement (19) est formée dans la paroi extérieure (24).

7. Carter (2) selon les revendications 5 et 6,
**caractérisé en ce**
**que** l'ouverture d'environnement (19) est orientée radialement et espacée axialement de la nervure (25).

8. Carter (2) selon la revendication 6 ou 7,
**caractérisé en ce**
**qu'**un collet extérieur (29) est formé sur la seconde zone de bord (21) au moins au niveau du labyrinthe de compensation de pression (15), qui fait saillie axialement dans l'environnement (16), est espacé radialement de la paroi extérieure (29) et chevauche axialement l'ouverture d'environnement (19).

9. Carter (2) selon l'une quelconque des revendications 1 à 8,
**caractérisé en ce**
- **que** l'ouverture d'environnement (19) dans la nervure (25) est formée selon la revendication 6, et/ou
- **que** l'ouverture d'environnement (19) est formée dans la seconde zone de bord (21) selon la revendication 4.

10. Carter (2) selon l'une quelconque des revendications 1 à 9,
**caractérisé en ce**
- **qu'**un élément de filtre (33) et/ou une membrane perméable aux gaz (35) sont disposés dans le labyrinthe de compensation de pression (15), ou
- **qu'**un élément de filtre (33) conçu comme une membrane perméable aux gaz (35) est disposé dans le labyrinthe de compensation de pression (15).

11. Carter (2) selon l'une quelconque des revendications précédentes,
**caractérisé en ce**
**que** le canal de labyrinthe (17) présente une courbure radiale (32) entre ses extrémités périphériques (30, 31).

12. Appareil de commande (36) avec au moins un élément électrique et/ou électronique (37) et avec un carter (2) selon l'une quelconque des revendications précédentes, dans lequel l'élément électrique et/ou électronique respectif (37) est disposé dans l'espace intérieur (5) du carter (2).

13. Appareil de réglage (1) pour actionner mécaniquement un composant d'une machine, de préférence un moteur à combustion interne,
- avec un moteur électrique (6) pour l'entraînement d'un organe de réglage (7) pour l'accouplement au composant à actionner, et
- avec un appareil de commande (36) selon la revendication 12 pour commander le moteur électrique (6),
- dans lequel il peut en particulier être prévu que le moteur électrique (6) est disposé dans l'espace intérieur (5) du carter (2) et que l'organe de réglage (7) est disposé à l'extérieur sur le carter (2).

14. Appareil de réglage (1) pour actionner mécaniquement un composant d'une machine, de préférence un moteur à combustion interne,
- avec un carter (2) selon l'une quelconque des revendications 1 à 12,
- avec un moteur électrique (6) disposé dans l'espace intérieur (5) du carter (2) pour l'entraînement d'un organe de réglage (7) disposé à l'extérieur sur le carter (2) pour l'accouplement au composant à actionner.
